# EUROPEAN PATENT APPLICATION

(11) **EP 0 642 858 A2**
(43) Date of publication of application: **15.03.1995**
(21) Application number: 94114150.9
(22) Date of filing: 08.09.1994
(51) Int. Cl.: B22F 1/02, B22F 9/00

(54) **Method and apparatus for production of composite ultrafine particles**

(30) Priority: 08.09.1993 JP 246062/93
(71) Applicant: YKK CORPORATION, Chiyoda-ku, Tokyo (JP); Masumoto, Tsuyoshi, Sendai-shi Miyagi-ken (JP); Inoue, Akihisa, Sendai-shi, Miyagi-ken (JP); HONDA GIKEN KOGYO KABUSHIKI KAISHA, Minato-ku Tokyo (JP)
(72) Inventor: Yamaguchi, Tadashi, Sendai-shi, Miyagi-ken (JP); Nosaki, Katsutoshi, Wako-shi, Saitama-ken (JP); Inoue, Akihisa, Aoba-ku, Sendai-shi, Miyagi-ken (JP); Masumoto, Tsuyoshi, Sendai-shi, Miyagi-ken (JP)
(74) Representative: Patentanwälte Leinweber & Zimmermann

(57) **Abstract**

A method and apparatus for the production of composite ultrafine particles having the surfaces of ultrafine particles coated with various metallic or ceramic materials are disclosed. The apparatus comprises a chamber (A) for the generation of ultrafine particles possessed of a gas inlet (10) and provided therein with a hearth (1 a) for seating an evaporation source (2) of ultrafine particles, a differential exhaust chamber (B) possessed of a gas outlet (11) and adapted to communicate with the chamber for the generation of ultrafine particles through the medium of a nozzle (4), and a chamber (C) for the deposition of ultrafine particles possessed of a gas outlet (12), provided therein with a hearth (1 c) for seating an evaporation source (8) of particles for deposition and a substrate (7), and adapted to communicate with the differential exhaust chamber through the medium of a communicating hole (5), the nozzle being so disposed as to have the leading end (4b) thereof positioned inside the differential exhaust chamber as opposed to the communicating hole. The ultrafine particles (3) generated in the chamber for the generation of ultrafine particles are passed through the nozzle into the chamber for the deposition of ultrafine particles and are coated with particles (9) for deposition generated therein and deposited on the substrate.

## Description

### BACKGROUND OF THE INVENTION

### 1. Field of the Invention:

This invention relates to a method and apparatus for the production of composite ultrafine particles, and more particularly to a method and apparatus for the production of composite ultrafine particles by the deposition of various materials on ultrafine particles of a varying substance.

### 2. Description of the Prior Art:

Heretofore, ultrafine particles have been manufactured by vaporizing a matrix as by means of resistance heating, arc melting, plasma heating, etc. To treat the surfaces of these ultrafine particles, the practice of heating these ultrafine particles and meanwhile exposing them to the flow of such a gas as N₂ or CH₄ thereby nitriding or carbonizing the surfaces or interiors of the ultrafine particles has been adopted.

Within the inventors' knowledge, however, no idea of coating the surfaces of ultrafine particles with various metallic or ceramic materials has ever been introduced to the art.

### SUMMARY OF THE INVENTION

The idea of producing composite ultrafine particles by coating the surfaces of ultrafine particles with a varying metallic or ceramic material is expected to allow development and manufacture of new materials which are endowed with various useful properties dependent on the kind of a substance forming the ultrafine particles to be coated and the kind of a metallic or ceramic coating material to coat the surfaces of the ultrafine particles.

It is, therefore, an object of the present invention to provide a method and apparatus for permitting efficient production of such composite ultrafine particles with a comparatively simple construction thereby allowing development and manufacture of novel materials endowed with various useful properties.

To accomplish the object described above, the present invention provides a method for the production of composite ultrafine particles by the steps of thermally melting an evaporation source of ultrafine particles in a gaseous atmosphere in a chamber for the generation of ultrafine particles thereby generating ultrafine particles, introducing the consequently generated ultrafine particles into a chamber for the deposition of ultrafine particles by virtue of a pressure difference between the chamber for the generation of ultrafine particles and the chamber for the deposition of ultrafine particles, and thermally vaporizing an evaporation source of particles for deposition in the chamber for the deposition of ultrafine particles thereby generating particles for deposition therein and allowing the particles for deposition to coat the introduced ultrafine particles.

In accordance with the present invention, there is further provided an apparatus for the production of composite ultrafine particles which is suitably used for implementing the method described above. This apparatus comprises (A) a chamber for the generation of ultrafine particles possessed of a gas inlet and provided therein with a hearth for seating an evaporation source of ultrafine particles, (B) a differential exhaust chamber possessed of a gas outlet and adapted to communicate with the chamber for the generation of ultrafine particles through the medium of a nozzle, and (C) a chamber for the deposition of ultrafine particles possessed of a gas outlet, provided therein with a hearth for seating an evaporation source of particles for deposition and a substrate, and adapted to communicate with the differential exhaust chamber through the medium of a communicating hole, the nozzle being so disposed as to have the leading end thereof positioned inside the differential exhaust chamber as opposed to the communicating hole. The apparatus is so operated that the inner pressures of the component chambers thereof may satisfy the relation, P_{A} > P_{B} > P_{c}, wherein P_{A} stands for the inner pressure of the chamber for the generation of ultrafine particles, P_{B} for the inner pressure of the differential exhaust chamber, and P_{c} for the inner pressure of the chamber for the deposition of ultrafine particles.

### BRIEF DESCRIPTION OF THE DRAWINGS

The other objects, features, and advantages of the present invention will become apparent from the following description taken together with the drawings, in which:
Fig. 1 is a diagram schematically illustrating the construction of one example of the apparatus of the present invention for the production of composite ultrafine particles;
Fig. 2 is a cross sectional view schematically illustrating Fe-Si0₂ composite ultrafine particles produced in Example 1;
Fig. 3 is a cross sectional view schematically illustrating AIN-Y₂0₃ composite ultrafine particles produced in Example 2;
Fig. 4 is a cross sectional view schematically illustrating A1₂0₃-Al composite ultrafine particles produced in Example 3;
Fig. 5 is a cross sectional view schematically illustrating an A1₂0₃ or Ti0₂-Pt or Pd composite ultrafine particles produced in Example 4; and
Fig. 6 is a fragmentary cross sectional view schematically illustrating another example of the apparatus of the present invention for the production of composite ultrafine particles.

### DETAILED DESCRIPTION OF THE INVENTION

The composite ultrafine particles according to the present invention are produced by thermally melting an evaporation source of ultrafine particles in a gaseous atmosphere within a chamber for the generation of ultrafine particles thereby generating very minute particles, introducing the produced ultrafine particles into a chamber for the deposition of ultrafine particles by virtue of a pressure difference between the chamber for the generation of ultrafine particles and the chamber for the deposition of ultrafine particles, heating the evaporation source of particles for deposition within the chamber for the deposition thereby generating a vapor of particles for deposition, and causing the introduced ultrafine particles to be coated with the particles for deposition and then deposited on a substrate. The apparatus for the production of composite ultrafine particles according to the present invention, therefore, comprises the three chambers, i.e. (A) the chamber for the generation of ultrafine particles (hereinafter referred to as the "generation chamber"), (B) the differential exhaust chamber, and (C) the chamber for the deposition of ultrafine particles (hereinafter referred to as the "deposition chamber"). The generation chamber is possessed of an inlet for introducing such gases as Ar, He, N₂, 0₂, and CH₄ which depend on the kind of ultrafine particles intended to be generated and adapted to generate ultrafine particles by thermally melting the evaporation source of ultrafine particles placed in a hearth disposed inside the chamber. The differential exhaust chamber is adapted to separate the ultrafine particles generated in the generation chamber from the gas of the gaseous atmosphere, introduce the separated ultrafine particles into the deposition chamber, and discharge the gas remaining after the separation. The deposition chamber is adapted to generate particles for deposition by heating the evaporation source of particles for deposition placed in a hearth inside the chamber and enable the ultrafine particles introduced from the differential exhaust chamber to be coated with the particles for deposition and deposited on a substrate.

The generation chamber and the differential exhaust chamber are allowed to intercommunicate through the medium of a nozzle, and the differential exhaust chamber and the deposition chamber are allowed to intercommunicate through the medium of a communicating hole disposed preferably at a position opposite the substrate. The nozzle has the leading end thereof disposed inside the differential exhaust chamber as opposed to the communicating hole. When the apparatus thus constructed is so operated that the inner pressures of the component chambers thereof may satisfy the relation, P_{A} > P_{B} > P_{c}, wherein P_{A} stands for the pressure in the generation chamber, P_{B} for the pressure in the differential exhaust chamber, and P_{c} for the pressure in the deposition chamber, the ultrafine particles generated in the generation chamber are allowed to flow smoothly without requiring any mechanical force toward the substrate set in place inside the deposition chamber and, in the process of this flow, are coated with the particles for deposition generated in the deposition chamber and eventually deposited on the substrate. Since the nozzle for introducing the ultrafine particles generated in the generation chamber into the deposition chamber has the leading end thereof disposed inside the differential exhaust chamber and also since the differential exhaust chamber has the interior thereof kept constantly in a state of exhaust, the ultrafine particles and the gas of the gaseous atmosphere which have been aspirated together into the nozzle are separated from each other at the time they are blown out of the leading end of the nozzle. The ultrafine particles thus separated are consequently allowed to flow toward the substrate through the communicating hole.

In consequence of the mechanism of the apparatus described above, composite ultrafine particles having the surfaces of very minute particles coated with particles for deposition can be efficiently deposited on the substrate.

Now, the present invention will be described in detail below with reference to examples which are illustrated in the accompanying drawings.

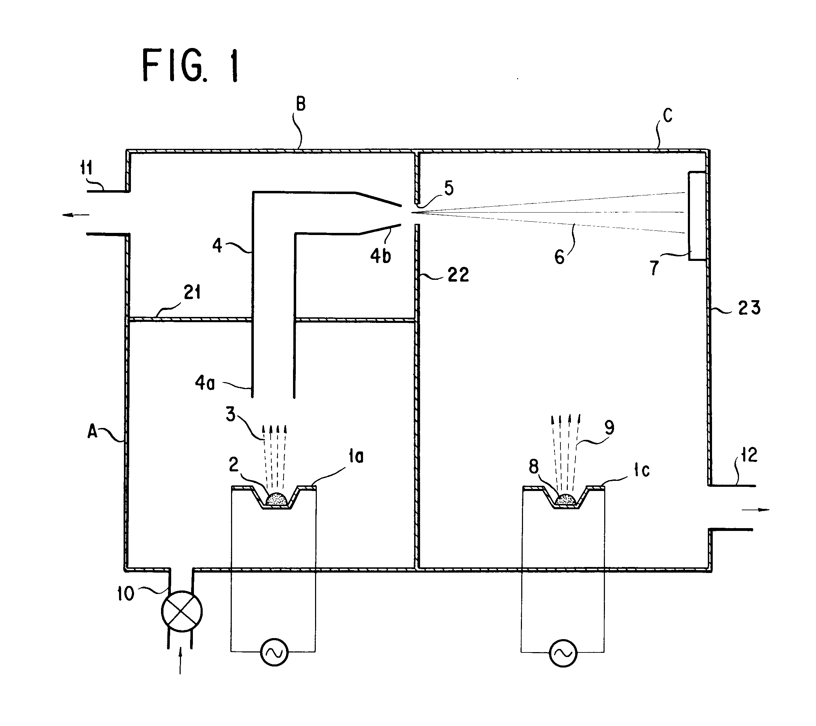

Fig. 1 schematically represents the construction of an apparatus for the production of composite ultrafine particles contemplated by the present invention. In Fig. 1, A stands for a generation chamber, B for a differential exhaust chamber, and C for a deposition chamber.

The generation chamber A has disposed therein a hearth 1 a for seating an evaporation source 2 of ultrafine particles of a composition desired to be generated and has connected thereto a gas inlet pipe 10 for introducing such gases as Ar, He, N₂, 0₂, and CH₄ which are used to form a gaseous atmosphere inside the chamber A.

A wall 21 which intervenes between the generation chamber A and the differential exhaust chamber B has a nozzle 4 disposed therethrough in such a manner that a trailing end 4a of the nozzle 4 may be positioned inside the generation chamber A and a leading end 4b thereof may be positioned inside the differential exhaust chamber B as opposed to a communicating hole 5 formed in a wall 22 partitioning the differential exhaust chamber B and the deposition chamber C. The differential exhaust chamber B has connected thereto an exhaust pipe 11 so adapted as to enable a gas introduced into the differential exhaust chamber B via a nozzle 4 to be discharged as by means of a mechanical booster pump (MBP).

Inside the deposition chamber C, a substrate 7 is disposed on a lateral wall 23 opposite the communicating hole 5 and a hearth 1 for seating an evaporation source 8 of a desired material to be coated on the ultrafine particles is set in place. Numeral 6 denotes a ray or flow of ultrafine particles just blown out of the leading end 4b of nozzle and numeral 12 an exhaust pipe connected to the deposition chamber C. Via this exhaust pipe 12, the deposition chamber C is evacuated with a diffusion pump (DP) or the like.

The methods which are available for the purpose of heating the evaporation source 2 of ultrafine particles in the generation chamber A include high frequency induction heating, electron beam heating, plasma jet heating, laser beam heating, and electric heating, for example, besides resistance heating. A suitable heating method may be employed depending on the kind of metal and the kind of gas to be used for the generation of ultrafine particles.

The methods which are available for the purpose of heating the evaporation source 8 of particles for deposition in the deposition chamber C include resistance heating, electron beam heating, and high frequency heating, for example. Optionally, a bias electrode may be installed inside the deposition chamber C for the purpose of enhancing the fastness of adhesion of a film to the ultrafine particles. For the sake of effecting the reactive deposition, it is allowable to generate a low temperature plasma in the deposition chamber C so as to exalt the reactivity of the particles for deposition enough to induce adhesion of ceramic clusters to the ultrafine particles.

Now, the positional relation of the nozzle mentioned above and the relation of inner pressures of the component chambers will be described in detail below.

### (1) Positional relation of the nozzle 4:

The differential exhaust chamber B must be constantly kept evacuated as with a mechanical booster pump so that the gas containing ultrafine particles 3 generated from the evaporation source 2 in the generation chamber A may be aspirated through the trailing end 4a of the nozzle 4, then caused to flow smoothly toward the leading end 4b of the nozzle 4, and finally discharged through the nozzle 4 as separated from the ultrafine particles 3. In this case, the gas is exclusively discharged from the differential exhaust chamber B via the exhaust pipe 11 and the ultrafine particles 3 are allowed to pass through the communicating hole 5 and enter the deposition chamber C. The differential exhaust chamber B thus plays the role of causing separation of the gas and the ultrafine particles during their passage across the leading end 4b of the nozzle and forcing the ultrafine particles to fly out of the communicating hole 5 toward the deposition chamber C. When the ultrafine particles to be produced in the generation chamber A are formed by use of a reactive gas, the differential exhaust chamber B also plays a role of preventing the reactive gas from leaking into the deposition chamber C and reacting with particles 9 for deposition to be generated within this chamber.

For this reason, the leading end 4b of the nozzle must exist inside the differential exhaust chamber B and is desired to be separated by a distance in the approximate range of from 10 to 200 mm from the communicating hole 5. The allowance of this ample range for the distance is desirable because this distance is variable in size, weight, and amount of ultrafine particles to be produced and further in the amount of gas (gas pressure) to be introduced into the generation chamber A.

As respects the positional relation between the generation chamber A and the trailing end 4a of the nozzle 4, it is desirable that the trailing end 4a of the nozzle existing inside the generation chamber A should be separated by a distance in the approximate range from 50 to 300 mm from the evaporation source 2. This range is necessary for the sake of allowing the distance to be varied with the gas pressure in the generation chamber A, the temperature of the evaporation source, and the kind of a metal to be used as the evaporation source. If the position of this trailing end 4a of the nozzle does not prove to be an optimum value under the condition mentioned above, the ratio of ultrafine particles 3 to be aspirated into the nozzle 4 will be decreased possibly to the extent of impairing the efficiency of the operation (amount of ultrafine particles utilized/amount thereof generated).

### (2) Relation of pressures of component chambers:

First, the inner pressure of the generation chamber A is desired to be maintained in the approximate range from several Torr (1 Torr = 1.33 x 10² Pa) to 2,000 Torr. If the inner pressure of the generation chamber A is less than several Torr, the particles which are generated at all are not very minute and resemble clusters of the size close to that of particles for deposition. Ultrafine particles will be producible even if the gas pressure exceeds the upper limit 2,000 Torr. If this gas pressure is unduly high, however, the flow of the gas blown out of the nozzle 4 will be very rapid and, as a result, not only the ultrafine particles but also the gas will enter the deposition chamber C.

Then, the inner pressure of the differential exhaust chamber B must be lower than that of the generation chamber A and higher than that of the deposition chamber C. Optimally, this inner pressure is desired to fall in the neighborhood of 0.1 Torr because the gas blown out of the leading end 4b of the nozzle is exclusively discharged by keeping this chamber evacuated at all times by use of a mechanical booster pump. If the gas pressure in the differential exhaust chamber B is unduly high, the gas will inevitably flow out of the differential exhaust chamber B into the generation chamber A. Conversely, if the gas pressure is unduly low, the gas blown out of the nozzle 4 will inevitably flow at an increased speed and the gas will leak into the deposition chamber C or the ultrafine particles will be infallibly aspirated abruptly together with the gas into the mechanical booster pump.

Finally, the inner pressure of the deposition chamber C is suitably fixed in the approximate range of from 10-⁵ to 10-⁴ Torr, in which vacuum deposition takes place.

Now, the procedure which is generally followed in the operation of the apparatus for the production of composite ultrafine particles mentioned above will be described below.
(A) A raw material destined to serve as the evaporation source 2 of ultrafine particles and a raw material desired to serve as the evaporation source 8 for coating the surfaces of the ultrafine particles are respectively disposed in the hearth 1 a in the generation chamber A and the hearth 1 c in the deposition chamber C.
(B) The generation chamber A, the differential exhaust chamber B, and the deposition chamber C are severally evacuated.
(C) The evacuation of the generation chamber A is discontinued and a gas such as Ar, He, N₂, 0₂, and CH₄ is fed in the chamber A until the pressure thereof reaches the neighborhood of 10 Torr.
(D) The evaporation sources 2 and 8 respectively in the generation chamber A and the deposition chamber C are heated to generate ultrafine particles 3 in the generation chamber A and vaporize particles 9 of the shape of clusters or atoms for deposition in the deposition chamber C.
(E) The ultrafine particles which are generated in the generation chamber A are aspirated together with the atmospheric gas into the trailing end 4a of the nozzle 4 and are blown out of the leading end 4b of the nozzle. Thereafter, the ultrafine particles are allowed to pass through the communicating hole 5 and enter the deposition chamber C.

The ultrafine particles which have entered the deposition chamber C collide with and are coated with the particles 9 of the shape of clusters or atoms for deposition generated from the evaporation source 8 in the deposition chamber C. As a result, the ultrafine particles are converted into composite ultrafine particles vested with a coating. The ultrafine particles which fly through the communicating hole 5 into the deposition chamber C are not readily affected by gravitational attraction because they have a size of the order of some tens of nm. Since they fly so fast, they do not descend inside the deposition chamber C. The ultrafine particles which have collided with the particles for deposition and have been consequently coated therewith keep the speed of flight intact inspite of the collision. Thus, these composite ultrafine particles land infallibly on the substrate 7 which is disposed on the lateral wall 23 of the deposition chamber C.

Optionally, the ultrafine particles and the particles of the shape of clusters or atoms for deposition may be so combined that the ultrafine particles will allow diffusion of atoms therein and consequent manufacture of an alloy. When gold of the shape of clusters or atoms is deposited on ultrafine particles of antimony, for example, the atoms of gold are diffused in the ultrafine particles of antimony to give rise to a gold-antimony alloy. By the same token, alloys such as of gold-copper and gold-zinc can be manufactured.

In accordance with the method and apparatus of the present invention for the production of composite ultrafine particles, various kinds of composite ultrafine particles can be obtained by varying the materials to be vaporized, the atmosphere of the site of production, and the amount of evaporation of ultrafine particles and clusters for deposition. Now, the particles to be produced by the method and apparatus of the present invention and the usages of these particles will be described with reference to a few working examples cited hereinbelow.

### Example 1:

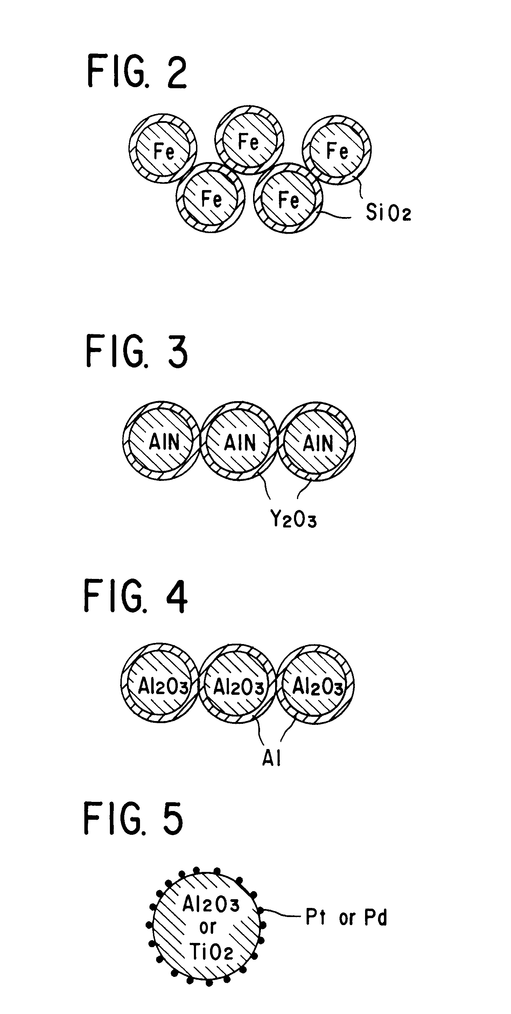

Production of Fe-Si0₂ composite ultrafine particles (material for cores of transformer and motors):
The production was carried out by the following procedure.
   (a) First, the generation chamber A, the differential exhaust chamber B, and the deposition chamber C were evacuated severally to a pressure of about 10-³ Pa.
   (b) An inert gas such as Ar or He was introduced to a pressure of about one atmosphere into the generation chamber A. This introduction of the inert gas was continued so as to keep the gas pressure in the generation chamber A intact constantly because the gas was fated to flow through the nozzle 4 and eventually depart from the differential exhaust chamber B.
   (c) A mixed gas consisting of a trifle (about 1 x 10-² Pa) of an inert gas and oxygen gas (having an oxygen gas content of about 50%) was introduced into the deposition chamber C and the deposition chamber C was kept constantly evacuated by means of DP (diffusion pump) and TMP (turbo molecular pump) in the same manner as in the step of (b) mentioned above so as to equilibrate the gas pressure therein.
   (d) Iron (Fe) as the evaporation source 2 was set in place in the generation chamber A and silicon (Si) as the evaporation source 8 in the deposition chamber C. Subsequently, the evaporation source 2 in the generation chamber A was thermally melted as by resistance heating to produce ultrafine Fe particles.
   (e) The evaporation source 8 in the deposition chamber C was thermally melted as by resistance heating to generate Si clusters. The Si clusters reacted with the oxygen gas in the atmosphere and converted into Si0₂ clusters.
   (f) As a result, ultrafine Fe particles having a diameter of some tens of nm were produced in the generation chamber A. These ultrafine Fe particles were passed through the nozzle 4 and, in the deposition chamber C, had the surfaces thereof coated uniformly with Si0₂, and were deposited on the substrate 7 to give rise to a film formed of Fe-Si0₂ composite ultrafine particles. Fig. 2 illustrates schematically the construction of these composite ultrafine particles. The composite ultrafine particles thus obtained had a size of some tens of nm.

The film thus composed of Fe-Si0₂ composite ultrafine particles retains the magnetizability inherent in the ultrafine Fe particles. Since the ultrafine Fe particles are wholly enclosed with an insulating coating of Si0₂, however, the film is rich in electric resistance. The film shows a highly satisfactory high-frequency characteristic and, unlike ordinary conductors, generates virtually no eddy current due to an induced electromotive force. Thus, the film can be used as the material for cores in transformers and motors, for example.

### Example 2:

Production of AIN-Y₂0₃ composite ultrafine particles (raw material for AIN substrate):
In the generation chamber A, nitrogen gas was introduced and aluminum (Al) was thermally vaporised to produce ultrafine AIN particles. In the deposition chamber C, yttrium (Y) was used as the evaporation source and oxygen gas was introduced to induce deposition of Y₂0₃ on the ultrafine AIN particles and give rise to composite ultrafine particles. Fig. 3 illustrates schematically the construction of these composite ultrafine particles. When AIN powder is sintered, this AIN powder is required to have uniformly incorporated therein several % by weight of Y₂0₃ as a sintering auxiliary. In the composite ultrafine particles which are obtained by the method of the present invention, the ultrafine AIN particles are individually coated with Y₂0₃ and, therefore, assume a state having the sintering auxiliary uniformly dispersed thereabout. As a result, the present invention permits production of an AIN powder which can be sintered very easily. When this AIN powder is sintered, the sintering auxiliary Y₂0₃ deposited in the form of a coating on the ultrafine AIN particles is diffused and the sintering of the powder is consequently allowed to proceed with fineness of the nano order.

### Example 3:

Production of AI₂0a-AI composite ultrafine particles (alumina particles with a low sintering temperature):
In the generation chamber A, oxygen gas was introduced and AI was thermally vaporized to produce ultrafine A1₂0₃ particles. In the deposition chamber C, AI was used as the evaporation source and vaporized in an atmosphere of an inert gas to produce composite ultrafine particles having AI deposited on the ultrafine A1₂0₃ particles. In this case, the AI film deposited as a coating on the ultrafine A1₂0₃ particles was given an extremely small thickness by decreasing the amount of AI to be deposited. Fig. 4 schematically illustrates the construction of these composite ultrafine particles. When the powder formed of these composite ultrafine particles is heated in an atmosphere of oxygen to a temperature in the approximate range of from 500 °C to 600 °C, the AI coats on the surfaces of the ultrafine particles are mutually fused and, at the same time, oxidized. Thus, a sintered body of A1₂0₃ is produced at a very low temperature.

### Example 4:

Production of A1₂0₃ or Ti0₂-Pt or Pd composite ultrafine particles (material for catalyst):
In the generation chamber A (filled with an atmosphere of oxygen), ultrafine particles of A1₂0₃ or Ti0₂ were produced. In the deposition chamber C (filled with an atmosphere of an inert gas), clusters of Pt or Pd were generated. By extremely decreasing the amount of Pt or Pd clusters so produced, particles having Pt or Pd deposited like islands in an ocean on the ultrafine A1₂0₃ or Ti0₂ particles as illustrated in Fig. 5 were manufactured. These composite ultrafine particles are useful as a catalyst as for NOx decomposition.

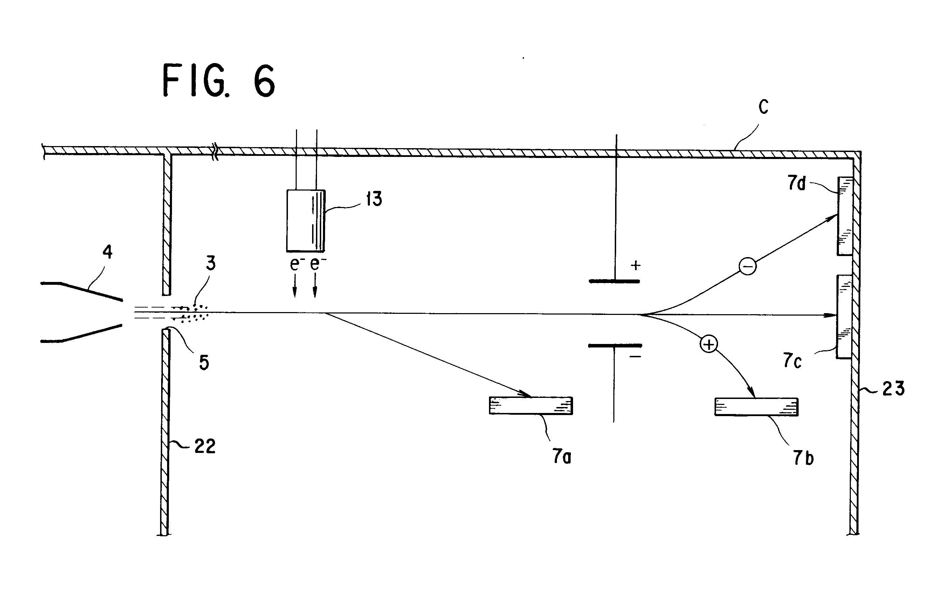

In the apparatus illustrated in Fig. 1, the substrate 7 is disposed as opposed to the communicating hole 5. Otherwise, the apparatus is constructed as illustrated in Fig. 6, wherein the ultrafine particles 3 are decelerated and electrically charged by an electric impulse from an electron gun 13 and, consequently, are caused to change the direction of their flight and land and deposit on a substrate 7a which is kept in a horizontal position. Alternatively, the ultrafine particles which have been charged electrically as described above are subsequently deflected by application of an electric field so as to be severally deposited at different positions. To be more specific, those ultrafine particles charged positively are caused to deposit on a substrate 7b which is kept in a horizontal position, those not charged on a substrate 7c which is set in place on the lateral wall 23 as opposed to the communicating hole 5, and those charged negatively on a substrate 7d which is installed at a position higher than that of the substrate 7c. Thus, the substrate can be placed arbitrarily in the deposition chamber C.

In accordance with the method and apparatus of the present invention which accomplish the production of composite ultrafine particles as described above, heretofore unknown composite ultrafine particles having the surfaces of ultrafine particles of a varying substance coated with varying metallic or ceramic materials can be manufactured efficiently with a relatively simple construction.

By the adoption of the method and apparatus of the present invention, therefore, novel composite ultrafine particles and ultrafine alloy particles which are endowed with various useful properties dependent on the kind of a substance forming the ultrafine particles to be coated and the kind of a metallic or ceramic coating material to coat the surfaces of the ultrafine particles can be developed and manufactured.

The invention may be embodied in other specific forms without departing from the spirit or essential characteristics thereof. The described embodiments are therefore to be considered in all respects as illustrative and not restrictive, the scope of the invention being indicated by the appended claims and all changes which come within the meaning and range of equivalency of the claims are, therefore, intended to be embraced therein.

## Claims

1. A method for the production of composite ultrafine particles, comprising the steps of:
thermally melting an evaporation source of ultrafine particles in a gaseous atmosphere in a chamber for generation of ultrafine particles thereby generating ultrafine particles,
introducing the consequently generated ultrafine particles into a chamber for deposition of ultrafine particles by virtue of a pressure difference between said chamber for the generation of ultrafine particles and said chamber for the deposition of ultrafine particles, and
thermally vaporizing an evaporation source of particles for deposition in said chamber for the deposition of ultrafine particles thereby generating particles for deposition therein and allowing said particles for deposition to coat the introduced ultrafine particles.

2. A method according to claim 1, wherein a differential exhaust chamber adapted to be maintained at a pressure lower than the inner pressure of said chamber for the generation of ultrafine particles and higher than the inner pressure of said chamber for the deposition of ultrafine particles is interposed between said chamber for the generation of ultrafine particles and said chamber for the deposition of ultrafine particles and said differential exhaust chamber serves as a site for separating said ultrafine particles generated in said chamber for the generation of ultrafine particles from the gas of said gaseous atmosphere and introducing the separated ultrafine particles into said chamber for the deposition of ultrafine particles.

3. A method according to claim 1, wherein said ultrafine particles generated in said chamber for the generation of ultrafine particles are introduced through the medium of a nozzle into said chamber for the deposition of ultrafine particles.

4. A method according to claim 2, wherein said ultrafine particles generated in said chamber for the generation of ultrafine particles are introduced into said chamber for the deposition of ultrafine particles through the medium of a nozzle having a trailing end thereof positioned in said chamber for the generation of ultrafine particles and a leading end thereof positioned in said differential exhaust chamber and therefore establishing intercommunication between said chamber for the generation of ultrafine particles and said differential exhaust chamber.

5. A method according to claim 2 or 4, wherein said differential exhaust chamber is kept evacuated at all times during the operation thereof.

6. A method according to claim 2, 4 or 5, wherein the inner pressure of said chamber for the generation of ultrafine particles is kept in the range of from several Torr to about 2,000 Torr, that of said differential exhaust chamber in the neighborhood of 0.1 Torr, and that of said chamber for the deposition of ultrafine particles in the range of from 10-⁵ to 10-⁴ Torr.

7. A method according to any one of claims 1 to 6, wherein said composite ultrafine particle comprises a metallic or ceramic ultrafine particle coated with a metallic or ceramic material.

8. An apparatus for the production of composite ultrafine particles, comprising:
(A) a chamber for generation of ultrafine particles possessed of a gas inlet and provided therein with a hearth for seating an evaporation source of ultrafine particles,
(B) a differential exhaust chamber possessed of a gas outlet and adapted to communicate with said chamber for the generation of ultrafine particles through the medium of a nozzle, and
(C) a chamber for deposition of ultrafine particles possessed of a gas outlet, provided therein with a hearth for seating an evaporation source of particles for deposition and a substrate, and adapted to communicate with said differential exhaust chamber through the medium of a communicating hole, said nozzle being so disposed as to have a leading end thereof positioned inside said differential exhaust chamber as opposed to said communicating hole.

9. An apparatus according to claim 8, which is operated so as to satisfy the relation, P_{A} > P_{B} > P_{c}, wherein P_{A} stands for the inner pressure of said chamber for the generation of ultrafine particles, P_{B} for the inner pressure of said differential exhaust chamber, and P_{c} for the inner pressure of said chamber for the deposition of ultrafine particles.

10. An apparatus according to claim 8 or 9, wherein said communicating hole is formed in a wall partitioning said differential exhaust chamber and said chamber for the deposition of ultrafine particles.

11. An apparatus according to claim 8, 9 or 10, wherein said substrate is disposed in said chamber for the deposition of ultrafine particles as opposed to said communicating hole.

12. An apparatus according to any one of claims 8 to 11, wherein a trailing end of said nozzle is disposed in said chamber for the generation of ultrafine particles as separated upwardly by a distance of from 50 to 300 mm from said evaporation source of ultrafine particles and the leading end thereof is disposed in said differential exhaust chamber as separated by a distance of from 10 to 200 mm from said communicating hole.
